## Europäisches Patentamt
## European Patent Office
## Office européen des brevets

(19)

(11) Veröffentlichungsnummer: **0 019 084**
**A1**

(12) ## EUROPÄISCHE PATENTANMELDUNG

(21) Anmeldenummer: 80101968.8

(22) Anmeldetag: 11.04.80

(51) Int. Cl.³: **H 03 F 1/32**
**H 04 B 1/12**

(30) Priorität: 20.04.79 DE 2915947

(43) Veröffentlichungstag der Anmeldung:
26.11.80 Patentblatt 80/24

(84) Benannte Vertragsstaaten:
AT BE CH DE FR GB IT LI LU NL SE

(71) Anmelder: SIEMENS AKTIENGESELLSCHAFT Berlin
und München
Postfach 22 02 61
D-8000 München 22(DE)

(71) Anmelder: Standard Elektrik Lorenz Aktiengesellschaft
Hellmuth-Hirth-Strasse 42
D-7000 Stuttgart 40(DE)

(71) Anmelder: TE KA DE Felten & Guilleaume
Fernmeldeanlagen GmbH
Thurn-und-Taxis-Strasse 10 Postfach 4943
D-8500 Nürnberg 1(DE)

(72) Erfinder: Heun, Hans J., Dipl.-Ing.
Bartningstrasse 12
D-6100 Darmstadt(DE)

(72) Erfinder: Kiesel, Kurt, Dipl.-Ing.
Im Eichenböhl 13a
D-6140 Bensheim 3(DE)

(74) Vertreter: Mehl, Ernst, Dipl.-Ing.
Postfach 22 01 76
D-8000 München 22(DE)

(54) Schaltungsanordnung zur Verminderung der amplitudenabhängigen Verzerrungen in Überlagerungsempfängern.

(57) Schaltungsanordnung zur Kompensation von nichtlinea-ren Verzerrungen in Überlagerungsempfängern, insbeson-dere in deren Eingangsteil unter Einschluß der Mischstufe. Eine derartige Linearisierung ist notwendig bei Mehrakana-lempfängern, die Signale mit stark unterschiedlichen Eingangsamplituden bei den verschiedenen Kanälen empfangen sollen. Ausgehend von einer Autokompensationsschaltung mit einem ersten Koppelnetzwerk (S(1)) zum Aufteilen des Eingangssignals auf zwei gleichphasige Verstärkerzweige, einem Hauptverstärker im ersten Verstärkerzweig, einem zweiten Koppelnetzwerk (S(2)) zwischen beiden Verstärker-zweigen, einem Hilfsverstärker hinter dem zweiten Koppel-netz (S(2)) im zweiten Verstärkerzweig und einem beide Ver-stärkerzweige wieder vereinigenden dritten Koppelnetzwerk (S(3)), ist in jeden der beiden Verstärkerzweige an gleicher Stelle je eine mit einem gemeinsamen Oszillator betriebene Frequenzumsetzerstufe eingefügt.

FIG 1

EP 0 019 084 A1

79 P 8 0 5 1 EUR

Die Erfindung betrifft eine Schaltungsanordnung zur
Kompensation von nichtlinearen, d. h. amplitudenabhängigen
Verzerrungen in Überlagerungsempfängern, insbesondere in
deren Eingangsteil unter Einschluß der Mischstufe.
Eine derartige Linearisierung ist notwendig bei Mehrkanalempfängern, die Signale mit stark unterschiedlichen Eingangsamplituden bei den verschiedenen Kanälen empfangen
sollen. Dieses Problem tritt z. B. beim öffentlich beweglichen Landfunk (öbL) auf. Der Empfang dieser Dienste wird
ohne Anwendung besonderer Maßnahmen wesentlich durch
Interkanalmodulation gestört.

Stand der Technik

Zur Verbesserung der amplitudenabhängigen Nichtlinearitäten
von Verstärkern sind im wesentlichen drei Verfahren bekannt,
die sich nach ihrer Arbeitsweise einordnen lassen in

    Gegenkopplung,
    Vorverzerrung,
    Autokompensation.

Diese Verfahren werden überwiegend bei Endstufen angewandt.

Die allgemein bekannte Gegenkopplung ist bei sehr hohen
Frequenzen aus Laufzeitgründen nicht mehr anwendbar und
scheidet bei niedrigen Frequenzen wegen der Erhöhung der
Rauschzahl auch für Empfangsschaltungen praktisch aus.

- 2 -

0019084

79 P 8051 EUR

Bei der insbesondere bei Senderendstufen erfolgreich
eingesetzten nichtlinearen Vorverzerrungsmethode wird
vor das zu entzerrende Übertragungssystem ein Korrekturglied mit einer komplementären Übertragungskennlinie geschaltet, wobei eine gegenphasige Addition des zunächst
gleichsinnig vorverzerrten Ausgangssignals mit dem unverzerrten Ursprungssignal erfolgt. Die Wiederherstellung
der ursprünglichen Amplitudenverhältnisse des Nutzsignals
zu den Verzerrungsanteilen wird dabei ohne Vergrößerung
der Verzerrungsanteile im Ausgangssignal des Korrekturgliedes erzielt. Auch bei der Anwendung dieser bekannten
Vorverzerrungsschaltung auf Empfänger muß eine unerwünschte
Erhöhung der Rauschzahl in Kauf genommen werden
(DT-PS 23 64 493).

Die Erfindung geht von der an sich bekannten Autokompensationsmethode aus, die bisher ebenfalls hauptsächlich auf Nf-Stufen
angewendet wurde, deren Anwendung auf HF und ZF-Stufen jedoch
grundsätzlich möglich erscheint. Bei diesem bekannten
Kompensationsverfahren, im angelsächsischen Sprachgebrauch
als "feed-forward" bezeichnet, geht man von zwei gleichphasigen parallelen Verstärkerzweigen mit zwei meist elektrisc
gleichen Verstärkern aus. Das Verfahren beruht darauf, daß die
Signalverzerrungen den Hauptverstärker im ersten Verstärkerzweig zunächst abgetrennt, in einem möglichst linearen Hilfsverstärker im zweiten Verstärkerzweig verstärkt und anschließend dem verzerrten Signal so zugesetzt werden, daß sich
die Verzerrungen bis auf die Restverzerrungen des Hilfsverstärkers auslöschen. Mit der Autokompensationsmethode lassen
sich jedoch die nicht zu vernachlässigenden Verzerrungen in
der Frequenzumsetzerstufe nicht mitlinearisieren, wenn man
sie in Überlagerungsempfängern einsetzen will
(DE-PS 10 85 194, US-PS 20 43 587).

BAD ORIGINAL

0019084

79 P 8051 EUR

## Aufgabe der Erfindung

Es ist die Aufgabe der Erfindung, die bekannte Autokompensationsmethode derart zu verbessern, daß eine
Verminderung der amplitudenabhängigen Verzerrungen eines
Empfängers unter Einbeziehung der Frequenzumsetzerstufe
ohne nennenswerte Beeinträchtigung der Eingangsempfindlichkeit, d. h. Erhöhung der Rauschzahl, möglich ist.

## Lösung

Dabei geht die Erfindung von der bekannten Autokompensationsschaltung aus, bestehend aus

a) einem ersten Koppelnetzwerk zum Aufteilen des Eingangssignals auf zwei parallele gleichphasige Verstärkerzweige,

b) einem Hauptverstärker im ersten Verstärkerzweig,

c) einem zweiten Koppelnetzwerk zwischen beiden Verstärkerzweigen zur amplitudengerechten Differenzbildung zwischen
   verstärktem und unverstärktem Signal,

d) einem Hilfsverstärker hinter dem zweiten Koppelnetzwerk
   im zweiten Verstärkerzweig zur Verstärkung der lediglich
   die Verzerrungen des Hauptverstärkers enthaltenden
   Differenzspannung,

e) ein beide Verstärkungszweige wieder vereinigendem drittem
   Koppelnetzwerk zur gegenphasigen Addition der Ausgangsspannungen von Hilfs- und Hauptverstärker.

Die oben erläuterte Aufgabe der Erfindung wird in der dargestellten bekannten Schaltungsanordnung nun dadurch gelöst,
daß in jeden der beiden Verstärkerzweige an gleicher Stelle
je eine mit einem gemeinsamen Oszillator betriebene Frequenzumsetzerstufe eingefügt ist.

79 P 8051 EUR

Die Erfindung beruht auf der Erkenntnis, daß die beiden
von einem gemeinsamen Oszillator gespeisten Frequenzumsetzer infolge ihrer kohärenten Arbeitsweise die Phasenbeziehungen nicht beeinflussen. Damit ist eine große
Freizügigkeit im Hinblick auf die Anordnung des zu
linearisierenden Hauptverstärkers und des die Kompensationsspannung erzeugenden Hilfsverstärkers im Hinblick auf ihre
Anordnung vor oder hinter den Frequenzumsetzerstufen gegeben,
d. h. Haupt- oder Hilfsverstärker können entweder im Hochfrequenz- oder im Zwischenfrequenzbereich betrieben werden.
Sie brauchen demzufolge nicht elektrisch gleich zu sein.

Im folgenden wird anhand von 7 Figuren die Erfindung
näher erläutert.

Es zeigen

Fig. 1 bis 4    vier verschiedene Ausführungsformen der
                erfindungsgemäßen Schaltungsanordnung,
Fig. 5          die Wirkungsweise der Ausführungsformen nach

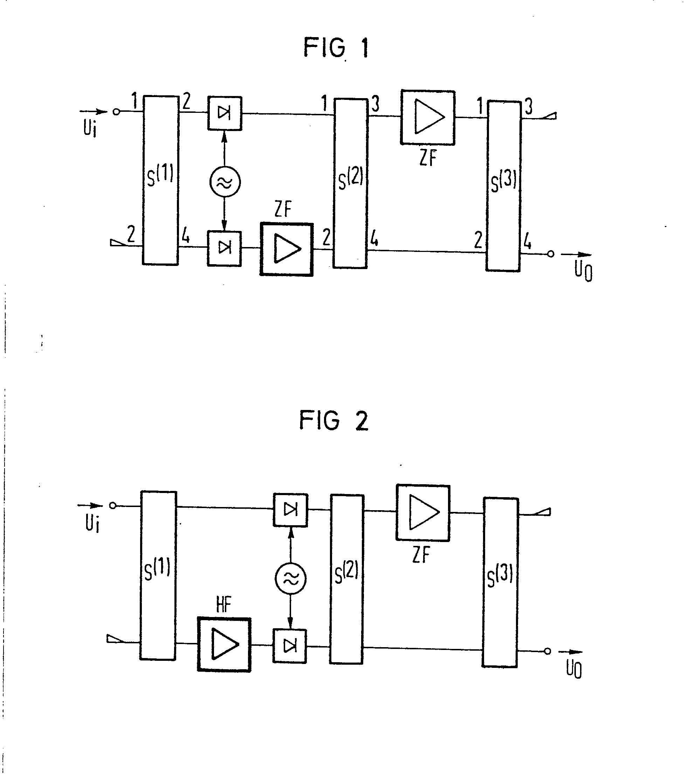

                Fig. 1 bis 4 im Diagramm,

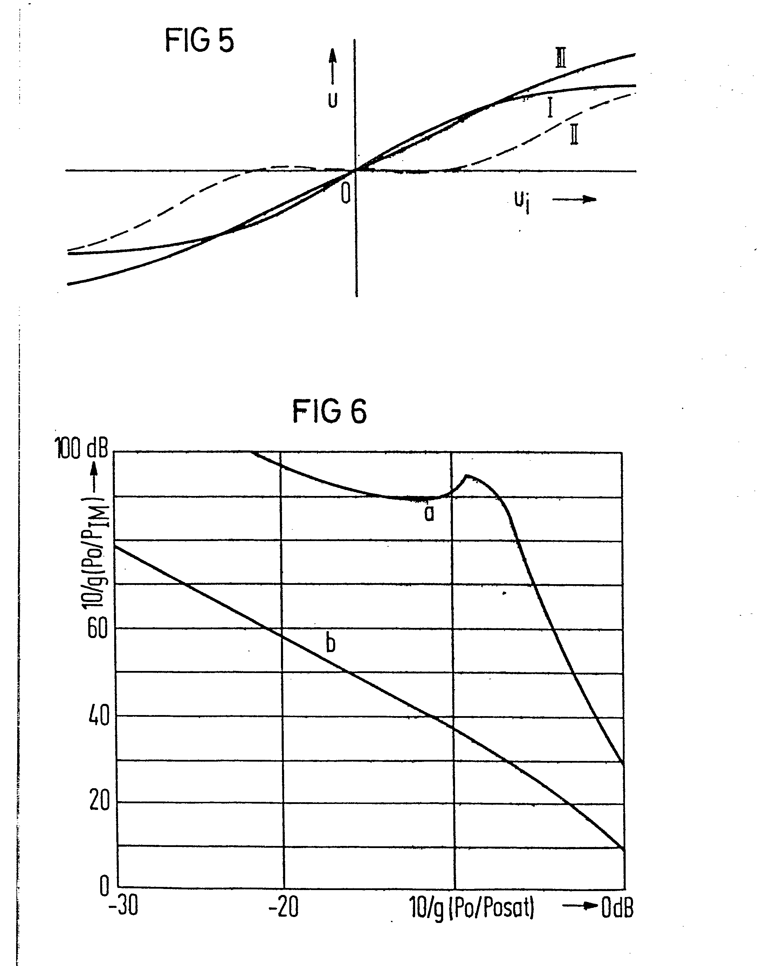

Fig. 6          den Verlauf der Intermodulationsdämpfung über
                der Ausgangsleistung,

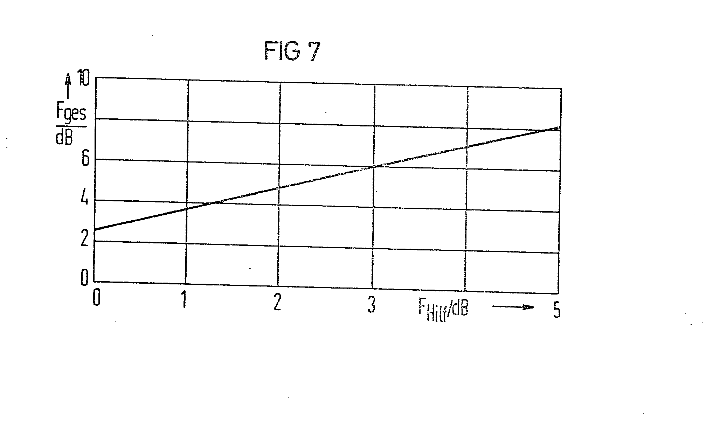

Fig. 7          den Verlauf der Gesamtrauschzahl über der
                Rauschzahl des Hilfsverstärkers bei einer
                Schaltungsanordnung nach Fig. 1.

Wie die Fig. 1 bis 4 zeigen, ist an jeweils verschiedener
Stelle der Figuren, aber an jeweils gleicher Stelle der
Verstärkerzweige innerhalb jeder Figur, in beide Verstärkerzweige je eine Frequenzumsetzerstufe eingefügt, die von
einem gemeinsamen Oszillator gespeist werden.

0019084

79 P 8051 EUR

In den Fig. 1 bis 4 ist der jeweils im unteren Verstärkerzweig abgebildete Hauptverstärker durch größere Strichstärke hervorgehoben.

Die 4 Ausführungsformen unterscheiden sich hinsichtlich
Rauschen und Aussteuerbereich.

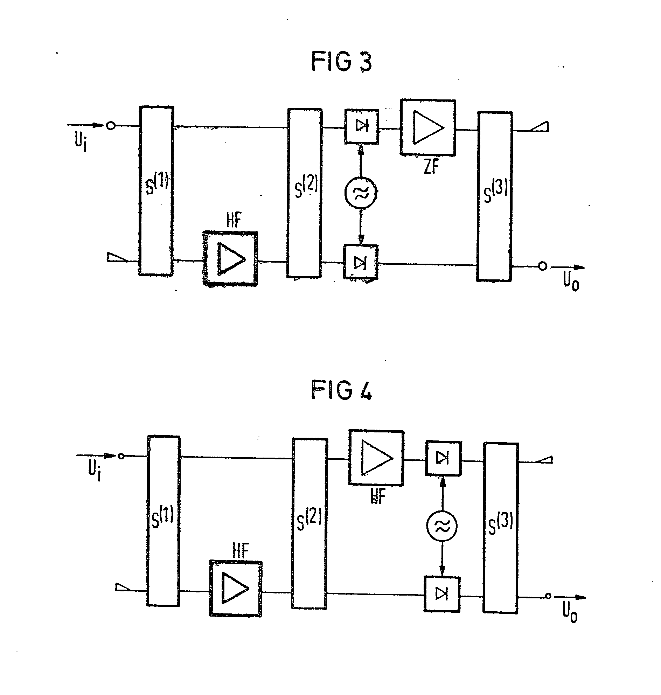

Bei der Schaltung nach Fig. 1 wird demzufolge der Linearisierungsaufwand überwiegend in die ZF-Ebene verlegt, die Schaltung nach Fig. 4 arbeitet überwiegend in der HF-Lage.
Die Schaltungsvarianten nach Fig. 2 und 3 unterscheiden sich
durch die Anordnung der Frequenzumsetzerstufen von den
übrigen Beispielen, bei Fig. 2 liegen die
Frequenzumsetzerstufen vor dem zweiten Koppelnetzwerk $S^{(2)}$,
bei Fig. 3 dahinter.

Die grundsätzliche Funktion ist für alle vier Schaltungsbeispiele gleich, da die Frequenzumsetzer infolge ihrer
kohärenten Arbeitsweise die Phasenbeziehungen nicht beeinflussen.

Die Linearisierung der Schaltungen beruht auf folgendem
Prinzip:
Das in Tor 1 des Koppelnetzwerkes $S^{(1)}$ eingespeiste Signal
wird auf die Tore 3 und 4 aufgeteilt. Am Tor 2 des
Kopplers $S^{(2)}$ liegt dann eine Spannung mit dem typischen
Kompressionscharakter als Funktion der Eingangsspannung
entsprechend Kurve I in Fig. 5 an. Die an Tor 3 des
Kopplers $S^{(2)}$ gebildete Differenzspannung hat an Tor 1 des
Kopplers $S^{(3)}$ einen Verlauf gemäß der gestrichelten Kurve II
in Fig. 5. Am Ausgang der Schaltung, am Tor 4 des
Kopplers $S^{(3)}$, entsteht eine linearisierte Ausgangsspannung
entsprechend Kurve III in Fig. 5. Diese setzt sich im

wesentlichen additiv aus den Kurven I und II der Fig. 5 zusammen, wobei gleichzeitig die Verzerrungen bis auf unvermeidliche Restverzerrungen reduziert werden.

Fig. 6 zeigt als obere Kurve a den gerechneten Verlauf der Intermodulationsdämpfung (entsprechend der Zweitonmethode) Po/PIM in Abhängigkeit von der Ausgangsleistung Po der Linearisierungsschaltung, bezogen auf die Sättigungsleistung Posat des Hauptverstärkers in doppelt logarith-mischem Maßstab. Zum Vergleich ist als untere Kurve b der entsprechende Verlauf für den nichtlinearisierten Fall aufgetragen.

Wesentlich für die breitbandige Arbeitsweise der Linearisierungsschaltungen ist die Gleichheit der elektrischen Länge in den jeweils parallelen Zweigen. Die für die Bildung der Spannungsdifferenzen erforderliche $180^o$-Phasendrehung wird durch die Verwendung geeigneter Koppelnetzwerke, z. B. Richt-koppler mit je $90^o$ Phasendrehung erreicht.

Ein besonders günstiges Rauschverhalten, verbunden mit einem geringeren Verstärkungsverlust der gesamten Linearisierungsschaltung und richtige Phasenbedingungen der beiden Verstärkerzweige ohne zusätzliche Phasendrehglieder ergaben sich, wenn das zweite Koppelnetzwerk $S^{(2)}$ als Viertorrichtkoppler ausgeführt wird.

Eine Folge der Linearisierung ist, daß bei vorgegebenen zulässigen Verzerrungen die nutzbare Ausgangsspannung der Schaltungen gegenüber dem nichtlinearisierten Fall erheblich vergrößert werden kann. Der Vorteil dieser Ausweitung des Dynamikbereiches zu hohen Aussteuerungen darf nicht durch

0019084

79 P 8051 EUR

eine entsprechende Verringerung der Empfindlichkeit
zunichte gemacht werden.

Genauere Untersuchungen der Schaltungen ergeben, daß das
Rauschen des Hauptverstärkers einschließlich seines vor-
oder nachgeschalteten Mischers im gleichen Maße wie die
Verzerrungen reduziert wird und somit in die Gesamtrauschzahl der Schaltung praktisch nicht eingeht. Aus diesem
Grund sind an den Hauptverstärker keine besonders hohen
Anforderungen in bezug auf die Rauschzahl zu stellen.

Zur Berechnung der Gesamtschaltung wurden für die Verstärker
und Frequenzumsetzer Kennlinien in Form von Exponentialfunktionen oder Polynomen unterlegt und die Werte der Koppelnetzwerke $S^{(1)}$, $S^{(2)}$ und $S^{(3)}$ nach einem Optimierungsverfahren für hohe Intermodulationsdämpfung innerhalb eines
großen Aussteuerbereichs ausgelegt.

Wie die Berechnung ergab, existieren für jedes der vier
Ausführungsbeispiele (Fig. 1 bis 4) optimal dimensionierte
Koppelnetzwerke, mit denen zusätzlich die Gesamtrauschzahl $F_{ges}$ der Schaltung minimal wird und im wesentlichen
nur noch von der Rauschzahl $F_{Hilf}$ des Hilfsverstärkers abhängt. Für die Schaltung nach Fig. 1 ist diese Abhängigkeit
in Fig. 7 im doppelt logarithmischen Maßstab dargestellt,
wobei der Konversionsverlust der Mischer mit 2 dB angenommen
wurde. Hieraus geht hervor, daß die Gesamtrauschzahl der
linearisierten Schaltung vergleichbar ist mit der Rauschzahl
einer konventionellen Empfängerschaltung, die Intermodulationsdämpfung nach Fig. 6 aber wesentlich über der konventionell
erreichbaren liegt.

Die angeführten Vorteile der Linearisierung werden mit einer
Einbuße der Kleinsignalverstärkung von ca. 7 dB erkauft.

0019084

- 1 -

79 P 8051 EUR

~~Schaltungsanordnung zur Verminderung der amplitudenab-~~
~~hängigen Verzerrungen in Überlagerungsempfängern~~

(6) Patentansprüche

1. Schaltungsanordnung zur Verminderung der amplitudenabhängigen Verzerrungen in Überlagerungsempfängern nach
   der Autokompensationsmethode, insbesondere im Eingangsteil von Mehrkanalempfängern mit stark unterschiedlichem
   Eingangspegel in verschiedenen Kanälen,
   bestehend aus
   a) einem ersten Koppelnetzwerk $\left(S^{(1)}\right)$ zum Aufteilen des
      Eingangssignals auf zwei parallele gleichphasige
      Verstärkerzweige,
   b) einem Hauptverstärker im ersten Verstärkerzweig,
   c) einem zweiten Koppelnetzwerk $\left(S^{(2)}\right)$ zwischen beiden
      Verstärkerzweigen zur amplitudengerechten Differenzbildung zwischen verstärktem und unverstärktem
      Signal,
   d) einem Hilfsverstärker hinter dem zweiten Koppelnetz-
      werk $\left(S^{(2)}\right)$ im zweiten Verstärkerzweig zur Verstärkung
      der lediglich die Verzerrungen des Hauptverstärkers
      enthaltenden Differenzspannung,
   e) ein beide Verstärkerzweige wieder vereinigendem
      dritten Koppelnetzwerk $\left(S^{(3)}\right)$ zur gegenphasigen
      Addition der Ausgangsspannungen von Hilfs- und
      Hauptverstärker,
      d a d u r c h   g e k e n n z e i c h n e t ,
      daß
   f) in jeden der beiden Verstärkerzweige an gleicher Stelle
      je eine mit einem gemeinsamen Oszillator betriebene
      Frequenzumsetzerstufe eingefügt ist (Fig. 1 bis 4).

79 P 8051 EUR

2. Schaltungsanordnung nach Anspruch 1,
dadurch gekennzeichnet,
daß die Frequenzumsetzerstufen vor dem Hauptverstärker
angeordnet sind (Fig. 1).

3. Schaltungsanordnung nach Anspruch 1,
dadurch gekennzeichnet,
daß die Frequenzumsetzerstufen nach dem Hauptverstärker
angeordnet sind (Fig. 2).

4. Schaltungsanordnung nach Anspruch 1,
dadurch gekennzeichnet,
daß die Frequenzumsetzerstufen vor dem Hilfsverstärker
angeordnet sind (Fig. 3).

5. Schaltungsanordnung nach Anspruch 1,
dadurch gekennzeichnet,
daß die Frequenzumsetzerstufen nach dem Hilfsverstärker
angeordnet sind (Fig. 4).

6. Schaltungsanordnung nach Anspruch 1,
dadurch gekennzeichnet,
daß das zweite Koppelnetzwerk $\left(S^{(2)}\right)$ zur Differenzbildung
als Viertorrichtkoppler ausgeführt ist.

1/4

FIG 1

FIG 2

0019084

FIG 3

FIG 4

0019084

FIG 5

FIG 6

4/4

FIG 7

**EUROPÄISCHER RECHERCHENBERICHT**

Europäisches
Patentamt

Nummer der Anmeldung
EP 80 10 1968

| EINSCHLÄGIGE DOKUMENTE | | | KLASSIFIKATION DER ANMELDUNG (Int.Cl. ¹) |
|---|---|---|---|
| Kategorie | Kennzeichnung des Dokuments mit Angabe, soweit erforderlich, der maßgeblichen Teile | betrifft Anspruch | H 03 F 1/32<br>H 04 B 1/12 |
| | DE - A - 2 622 954 (LABORATOIRE GENERAL DES TELECOMMUNICATIONS)<br><br>* Seite 4, Zeile 9 - Seite 9, Zeile 17; Figuren *<br><br>-- | 1 | |
| A | DE - A - 2 409 842 (WESTERN ELECTRIC CO.)<br><br>* Seite 6, Zeile 20 - Seite 17, Zeile 14; Figuren *<br><br>-- | 1 | |
| A | DE - A - 2 019 104 (WESTERN ELECTRIC CO.)<br><br>* Seite 6, Zeile 14 - Seite 28, Zeile 6; Figuren 2-4 *<br><br>-- | 1 | RECHERCHIERTE SACHGEBIETE (Int. Cl. ³)<br><br>H 03 F 1/32<br>H 04 B 1/10<br>         1/12<br>         1/26<br>         3/06<br>         7/015 |
| A | GB - A - 802 218 (STANDARD TELEPHONES AND CABLES)<br><br>* Seite 1, Zeile 76 - Seite 3, Zeile 18; Figuren *<br><br>-- | 1 | H 03 D 7/00 |
| A | US - A - 4 126 828 (MORIO KUMAGAI)<br><br>* Spalte 5, Zeile 65 - Spalte 7, Zeile 38; Figur 4 *<br><br>---- | 1 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsatze
E: kollidierende Anmeldung
D: in der Anmeldung angeführtes Dokument
L: aus andern Grunden angeführtes Dokument
&: Mitglied der gleichen Patentfamilie, ubereinstimmendes Dokument

Der vorliegende Recherchenbericht wurde für alle Patentansprüche erstellt

| Recherchenort. | Abschlußdatum der Recherche | Prüfer |
|---|---|---|
| Den Haag | 28-07-1980 | MINNOYE |